# EUROPÄISCHE PATENTSCHRIFT

(11) **EP 1 770 767 B1**
(45) Veröffentlichungstag und Bekanntmachung des Hinweises auf die Patenterteilung: **28.05.2014**
(21) Anmeldenummer: 06019935.3
(22) Anmeldetag: 22.09.2006
(51) Int. Cl.: H01L 21/20, H01L 21/02, H01L 33/02, H01L 33/04, H01L 33/30

(54) **Halbleitersubstrat aus GaAs und Halbleiterbauelement**
GaAs semiconductor substrate and semiconductor device
Substrat semiconducteur à GaAs et dispositif semiconducteur

(30) Priorität: 30.09.2005 DE 102005046943; 29.11.2005 DE 102005056950
(43) Veröffentlichungstag der Anmeldung: 04.04.2007
(73) Patentinhaber: OSRAM Opto Semiconductors GmbH, 93055 Regensburg (DE)
(72) Erfinder: Linder, Norbert, 93138 Lappersdorf (DE); Grönninger, Günther, 92358 Seubersdorf (DE); Heidborn, Peter, 93197 Zeitlarn (DE); Streubel, Klaus, 93164 Laaber (DE); Kugler, Siegmar, 93055 Regensburg (DE)
(74) Vertreter: Epping - Hermann - Fischer

(56) Entgegenhaltungen:
- DE-A1- 10 345 413
- JP-A- 5 347 431
- US-A1- 2003 138 015
- TETSUO SOGA: "VERY LOW DISLOCATION DENSITY GAAS ON SI USING SUPERLATTICES GROWN BY MOCVD" JOURNAL OF CRYSTAL GROWTH, ELSEVIER, AMSTERDAM, NL, Bd. 107, Nr. 1 / 04, 1. Januar 1991 (1991-01-01), Seiten 479-482, XP000246641 ISSN: 0022-0248
- NAGANO M ET AL: "Epitaxial growth and photoluminescence of AlAs/GaP short-period superlattices" JOURNAL OF CRYSTAL GROWTH, ELSEVIER, AMSTERDAM, NL, Bd. 227-228, 1. Juli 2001 (2001-07-01), Seiten 275-278, XP004250840 ISSN: 0022-0248
- RUSAKOVA I A ET AL: "Stress analysis in strain compensated arsenide/phosphide superlattices grown by chemical beam epitaxy. Part 2" MICROELECTRONICS JOURNAL, MACKINTOSH PUBLICATIONS LTD. LUTON, GB, Bd. 31, Nr. 5, 1. Mai 2000 (2000-05-01), Seiten 323-331, XP004193975 ISSN: 0026-2692

## Beschreibung

Die Erfindung betrifft ein Halbleitersubstrat aus GaAs mit einer darauf aufgebrachten Halbleiterschichtenfolge und ein Halbleiterbauelement mit einem derartigen Halbleitersubstrat.

Für die Herstellung von elektronischen oder optoelektronischen Halbleiterbauelementen wäre es wünschenswert, Substrate mit einer kubischen Gitterstruktur und einer Gitterkonstante, die zwischen den Gitterkonstanten von GaAs und GaP liegt, zur Verfügung zu haben. Derartige Substrate könnten zum epitaktischen Aufwachsen von III-V-Halbleiterschichten oder II-VI-Halbleiterschichten, insbesondere ternären oder quaternären Verbindungen, verwendet werden, die eine Gitterkonstante zwischen denen von GaAs und GaP aufweisen und sich bisher nicht in ausreichender Qualität oder nur mit vergleichsweise großem Herstellungsaufwand herstellen lassen.

Elementare oder binäre Halbleitermaterialien mit einer Gitterkonstante, die zwischen denen von GaAs und GaP liegt, sind allerdings nicht bekannt. Weiterhin sind ternäre Halbleiterverbindungen wie GaAsP oder InAlGaP mit den bekannten Kristallzüchtungsverfahren nicht oder nur mit schlechter Kristallqualität direkt als Substratmaterialien herstellbar.

Ein Ansatz zur Lösung dieses Problems besteht darin, eine vergleichsweise dicke Bufferschicht, beispielsweise aus GaAsP, auf ein GaAs-Substrat aufzuwachsen, um auf diese Weise ein Quasisubstrat mit einer geringeren Gitterkonstante als GaAs zu erzeugen. Dabei sind aber vergleichsweise große Schichtdicken von typischerweise mehr als 10 µm erforderlich, um die durch die Gitterfehlanpassung zwischen dem Substrat und der Bufferschicht bedingten Kristalldefekte, insbesondere Versetzungen, in Wachstumsrichtung der Bufferschicht derart zu vermindern, dass ein epitaktisches Aufwachsen weiterer Halbleiterschichten auf der Oberfläche der Bufferschicht in ausreichender Qualität möglich ist.

Weiterhin hat es sich als nachteilig herausgestellt, dass ein mit einer derartigen Bufferschicht versehener Halbleiterwafer eine vergleichsweise große Durchbiegung aufweist, die durch eine nicht vollständige Relaxation der Bufferschicht und der daraus resultierenden Schichtspannung bedingt ist.

DE 103 45 413 A1 und US 2003/0 138 015 A1 offenbaren Quasisubstrate mit Schichten im InGaAlAsP-System.

Der Erfindung liegt die Aufgabe zugrunde, ein verbessertes Quasisubstrat mit einer Gitterkonstante, die geringer als die Gitterkonstante von GaAs ist, und ein Halbleiterbauelement mit einem derartigen Quasisubstrat anzugeben. Insbesondere soll sich das Quasisubstrat durch eine vergleichsweise hohe Kristallqualität, die das epitaktische Aufwachsen weiterer Halbleiterschichten mit einer geringeren Gitterkonstante als GaAs in hoher Qualität ermöglicht, und einen vergleichsweise geringen Herstellungsaufwand auszeichnen.

Diese Aufgabe wird durch ein optoelektronisches Bauelement mit einem Halbleitersubstrat aus GaAs mit einer darauf aufgebrachten Halbleiterschichtenfolge mit den Merkmalen des Patentanspruchs 1 gelöst. Vorteilhafte Ausgestaltungen der Erfindung sind Gegenstand der abhängigen Ansprüche.

Bei einem Halbleitersubstrat aus GaAs mit einer darauf aufgebrachten Halbleiterschichtenfolge enthält die Halbleiterschichtenfolge gemäß der Erfindung eine Mehrzahl von Halbleiterschichten aus Al_{1-y}GayAs₁₋ₓPₓ mit 0 ≤ x ≤ 1 und 0 ≤ y ≤ 1, wobei mehrere der Halbleiterschichten, vorzugsweise mindestens 3 Halbleiterschichten, jeweils einen Phosphoranteil x aufweisen, der größer als in einer benachbarten, in Wachstumsrichtung der Halbleiterschichtenfolge darunter liegenden Halbleiterschicht ist.

Es hat sich herausgestellt, dass eine derartige auf ein Halbleitersubstrat aus GaAs aufgebrachte Halbleiterschichtenfolge aus mehreren Al_{1-y}Ga_{y}AS₁₋ₓPₓ-Schichten eine vergleichsweise hohe Kristallqualität aufweist. Dadurch, dass der Phosphoranteil x in Wachstumsrichtung der Halbleiterschichtenfolge an mehreren Grenzflächen zwischen aneinander angrenzenden Halbleiterschichten ansteigt, wird eine Ausbreitung von Kristalldefekten, insbesondere Versetzungen, über mehrere Halbleiterschichten erschwert und auf diese Weise die Kristallqualität verbessert. Insbesondere hat sich herausgestellt, dass die Ausbreitung von Versetzungen aufgrund der sprunghaften Änderung des Phosphoranteils und der damit verbundenen sprunghaften Änderung der Gitterkonstante innerhalb der Halbleiterschichtenfolge im Vergleich zu Bufferschichten mit gradueller oder konstanter Zusammensetzung vermindert ist.

Vorteilhaft weist die oberste Schicht der Halbleiterschichtenfolge eine kleinere Gitterkonstante auf als das GaAs-Substrat. Das GaAs-Substrat mit der darauf aufgebrachten Halbleiterschichtenfolge kann insbesondere als Quasisubstrat zum epitaktischen Aufwachsen weiterer Halbleiterschichten, die eine kleinere Gitterkonstante aufweisen als GaAs, verwendet werden.

Insbesondere können für strahlungsdetektierende oder strahlungsemittierende optoelektronische Bauelemente geeignete funktionelle Halbleiterschichten aus III-V-Halbleitermaterialien oder II-VI-Halbleitermaterialien mit geringeren Gitterkonstanten als GaAs epitaktisch auf das Quasisubstrat aufgewachsen werden.

Die Halbleiterschichtenfolge enthält eine Anzahl aneinander angrenzender Halbleiterschichten mit jeweils festem Phosphoranteil x, wobei sich der Phosphoranteil x in Wachstumsrichtung schrittweise von einer Halbleiterschicht zur jeweils angrenzenden nachfolgenden Halbleiterschicht erhöht. Besonders bevorzugt erhöht sich der Phosphoranteil x von einer Halbleiterschicht zur nachfolgenden Halbleiterschicht jeweils um den gleichen Betrag. Die Anzahl der aufeinander folgenden Halbleiterschichten, in denen der Phosphoranteil x stufenweise ansteigt, beträgt vorteilhaft 4 oder mehr. Weiterhin beträgt die Anzahl der Halbleiterschichten, in denen der Phosphoranteil x stufenweise ansteigt, vorteilhaft nicht mehr als 10.

Die Halbleiterschichtenfolge enthält eine Übergitterstruktur aus alternierenden ersten und zweiten Halbleiterschichten aus Al_{1-y}Ga_{y}As₁₋ₓPₓ, wobei die ersten Halbleiterschichten einen Phosphoranteil x₁ ≥ 0 und die zweiten Halbleiterschichten einen Phosphoranteil x₂ ≥ 0 mit x₁ ≠ x₂ enthalten. Mit einer derartigen Übergitterstruktur als alternierenden Schichten mit verschiedenem Phosphoranteil kann die Ausbreitung von Versetzungen in der Halbleiterschichtenfolge besonders effektiv vermindert werden.

Für den Phosphoranteil x in der obersten Halbleiterschicht der Halbleiterschichtenfolge gilt vorzugsweise x ≥ 0,15. Auf diese Weise kann insbesondere erreicht werden, dass die Gitterkonstante in der obersten Halbleiterschicht der Halbleiterschichtenfolge um mehr als 0,5 % kleiner ist als die Gitterkonstante von GaAs. Besonders bevorzugt gilt für den Phosphoranteil x in der in der obersten Halbleiterschicht der Halbleiterschichtenfolge x ≥ 0,2, um eine im Vergleich zu GaAs um mindestens 0,7 % kleinere Gitterkonstante in der obersten Halbleiterschicht zu erzielen.

Bei einer weiteren bevorzugten Ausführungsform der Erfindung gilt für den Aluminiumanteil 1 - y in der Halbleiterschichtenfolge 1 - y = 0. In diesem Fall basiert die Halbleiterschichtenfolge also auf GaAs₁₋ₓPₓ.

Die erfindungsgemäße Halbleiterschichtenfolge hat insbesondere den Vorteil, dass mit einer vergleichsweise geringen Gesamtdicke der Halbleiterschichtenfolge ein Quasisubstrat mit hoher Kristallqualität und geringer Versetzungsdichte erzeugt werden kann. Besonders bevorzugt beträgt die Gesamtdicke der Halbleiterschichtenfolge 10 µm oder weniger. Die Halbleiterschichten der Halbleiterschichtenfolge weisen vorzugsweise eine Dicke zwischen einschließlich 100 nm und einschließlich 1000 nm auf.

Das optoelektronisches Bauelement kann, zum Beispiel, eine Lumineszenzdiode oder ein Halbleiterlaser sein.

Das optoelektronische Bauelement enthält insbesondere eine strahlungsdetektierende oder eine strahlungsemittierende aktive Schicht. Die strahlungsdetektierende oder strahlungsemittierende aktive Schicht ist in einer weiteren Halbleiterschichtenfolge enthalten, die auf der auf das Substrat aufgebrachten Halbleiterschichtenfolge epitaktisch aufgewachsen ist. In diesem Fall fungiert das GaAs-Substrat mit der darauf aufgebrachten Halbleiterschichtenfolge also als Quasisubstrat für die weitere Halbleiterschichtenfolge, die die funktionellen Halbleiterschichten des optoelektronischen Bauelements, insbesondere eine strahlungsemittierende oder strahlungsdetektierende Schicht, enthält.

Die strahlungsdetektierende oder strahlungsemittierende Schicht kann insbesondere InₓAl_{y}Ga_{1-x-y}P mit 0 ≤ x < 0,5, 0 ≤ y ≤ 1 und x + y ≤ 1 enthalten. Alternativ ist es auch möglich, dass die strahlungsdetektierende oder strahlungsemittierende Schicht eines der Halbleitermaterialien ZnSe, ZnSSe, ZnMgSSe, MgS, GaAsN oder InGaAsN enthält.

Die Halbleiterschichten der Halbleiterschichtenfolge sind vorzugsweise metamorphe Halbleiterschichten. Dies bedeutet insbesondere, dass die Halbleiterschichten zumindest nahezu unverspannt auf dem GaAs-Substrat oder der jeweils darunter liegenden Halbleiterschicht aufwachsen. Die Halbleiterschichten werden dazu vorzugsweise bei einer Temperatur von 700°C oder weniger, beispielsweise im Bereich zwischen 450 °C und 700°C aufgewachsen.

Durch das metamorphe Wachstum der Halbleiterschichten werden Schichtspannungen, die durch die unterschiedlichen Gitterkonstanten der Halbleiterschichten und/oder dem GaAs-Substrat bedingt sind, weitgehend vermieden. Eine ansonsten auftretende Durchbiegung des Halbleitersubstrats aufgrund von Schichtspannungen wird dadurch vermindert.

Vorzugsweise ist mindestens eine der Halbleiterschichten, insbesondere die oberste Halbleiterschicht, relaxiert.

Es hat sich herausgestellt, dass die Relaxation der obersten Halbeleiterschicht dadurch gefördert werden kann, dass zumindest eine der darunter liegenden Halbleiterschichten eine kleinere Gitterkonstante aufweist. Bei einer bevorzugten Ausführungsform weist die oberste Halbleiterschicht der Halbleiterschichtenfolge eine kleinere Gitterkonstante auf als die beiden ihr unmittelbar vorangehenden Halbleiterschichten.

Die Erfindung wird im Folgenden anhand von vier Ausführungsbeispielen im Zusammenhang mit den Figuren 1 bis 4 näher erläutert.

Es zeigen:
Figur 1A eine schematische Darstellung eines Querschnitts durch ein Halbleitersubstrat mit einer darauf aufgebrachten Halbleiterschichtenfolge,
Figur 1B eine grafische Darstellung des Phosphoranteils x und der relativen Änderung ε der Gitterkonstante in Abhängigkeit von einer Ortskoordinate z,
Figur 2A eine schematische Darstellung eines Querschnitts durch ein Halbleitersubstrat mit einer darauf aufgebrachten Halbleiterschichtenfolge gemäß einem Ausführungsbeispiel der Erfindung,
Figur 2B eine grafische Darstellung des Phosphoranteils x und der relativen Änderung ε der Gitterkonstante in Abhängigkeit von einer Ortskoordinate z bei dem Ausführungsbeispiel,
Figur 3A eine schematische Darstellung eines Querschnitts durch ein Halbleitersubstrat mit einer darauf aufgebrachten Halbleiterschichtenfolge,
Figur 3B eine grafische Darstellung des Phosphoranteils x und der relativen Änderung ε der Gitterkonstante in Abhängigkeit von einer Ortskoordinate z,
Figur 4 eine schematische Darstellung eines Querschnitts durch ein Halbleiterbauelements, und
Figur 5 eine grafische Darstellung der relativen Änderung ε der Gitterkonstante in Abhängigkeit von einer Ortskoordinate z.

Gleiche oder gleichwirkende Elemente sind in den Figuren mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

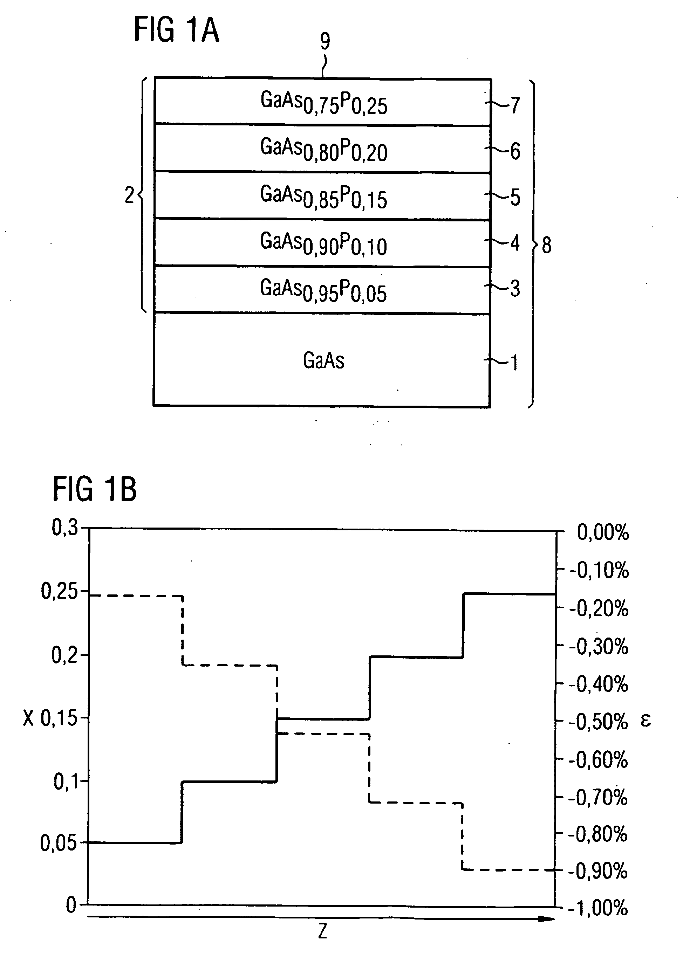

Auf das in Figur 1A schematisch im Querschnitt dargestellte Halbleitersubstrat 1 aus GaAs ist eine Halbleiterschichtenfolge 2 aufgebracht, die aus mehreren GaAsP-Schichten besteht. Die Halbleiterschichtenfolge 2 enthält ausgehend vom GaAs-Substrat eine GaAs_{0,95}P_{0,05}-Schicht 3, eine GaAS_{0,90}P_{0,10}-Schicht 4, eine GaAs_{0,85}P_{0,15}-Schicht 5, eine GaAs_{0,80}P_{0,20}-Schicht 6 und eine GaAs_{0,75}P_{0,25}-Schicht 7. Insgesamt enthält die Halbleiterschichtenfolge 2 also fünf Halbleiterschichten 3, 4, 5, 6, 7 aus GaAs₁₋ₓPₓ, wobei der Phosphoranteil x von einem Wert von x = 0,05 in der an das GaAs-Substrat 1 angrenzenden Halbleiterschicht 3 auf einen Wert x = 0,25 in der obersten Halbleiterschicht 7 stufenweise ansteigt. Dabei erhöht sich der Phosphoranteil der Halbleiterschichten gegenüber der jeweils darunter liegenden Halbleiterschicht um einen Betrag Δx = 0,05.

Das Halbleitersubstrat 1 aus GaAs mit der darauf aufgebrachten Schichtenfolge 2 stellt ein Quasisubstrat 8 dar, auf dessen Oberfläche 9 insbesondere weitere Halbleiterschichten oder Halbleiterschichtenfolgen aufgewachsen werden können. Insbesondere können auf die Oberfläche 9 des Quasisubstrats 8 Halbleiterschichten epitaktisch aufgewachsen werden, die eine kleinere Gitterkonstante als GaAs aufweisen. Dies ist vorteilhaft möglich, da die oberste Halbleiterschicht 7 aufgrund ihres Phosphoranteils eine kleinere Gitterkonstante aufweist als das GaAs-Substrat 1.

Der Zusammenhang zwischen dem Phosphoranteil x und der Gitterkonstante der GaAs₁₋ₓPₓ-Halbleiterschichten wird in Figur 1B näher erläutert, in der der Verlauf des Phosphoranteils x und der relativen Änderung der Gitterkonstante ε = (d-d₀)/d₀ in Abhängigkeit von einer vom Substrat 1 ausgehenden Ortskoordinate z, die in Wachstumsrichtung der Halbleiterschichtenfolge verläuft, dargestellt ist. Dabei ist d₀ die Gitterkonstante des GaAs-Substrats 1 und d die Gitterkonstante der jeweiligen GaAs₁₋ₓPₓ-Schicht.

Der stufenförmige Anstieg des Phosphoranteils x (durchgezogene Linie) in der Halbleiterschichtenfolge führt zu einer stufenförmigen Verminderung der Gitterkonstante d.

Beispielsweise wird durch die Erhöhung des Phosphoranteils x auf einen Wert von x = 0,25 in der obersten Halbleiterschicht 7 eine Verminderung der Gitterkonstante d gegenüber der Gitterkonstante d₀ des GaAs-Substrats 1 um etwa 0,9 % erzielt.

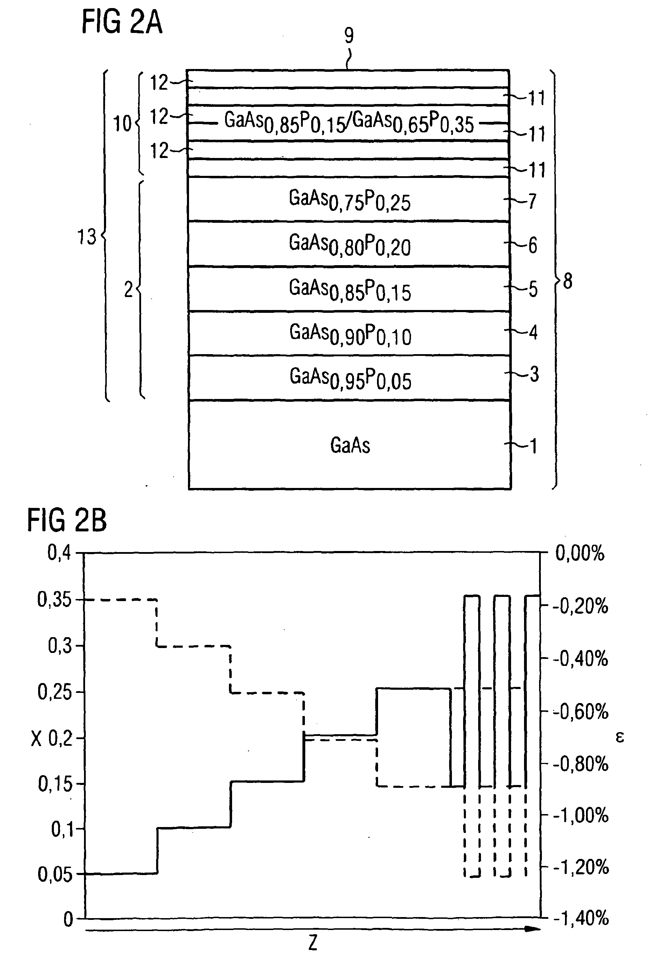

Bei dem in Figur 2A schematisch im Querschnitt dargestellten Halbleitersubstrat 1 mit einer darauf aufgebrachten Halbleiterschichtenfolge 13 gemäß einem Ausführungsbeispiel der Erfindung sind wie in Figur 1A fünf Halbleiterschichten 3, 4, 5, 6, 7 auf einem GaAs-Substrat 1 angeordnet, in denen der Phosphoranteil stufenweise von x = 0,05 auf x = 0,25 ansteigt. Auf die Halbleiterschichten 3, 4, 5, 6, 7 mit stufenförmigen Anstieg des Phosphoranteils ist eine Übergitterstruktur 10, die drei Schichtpaare aus jeweils einer ersten Halbleiterschicht 11 aus GaAS_{0,85}P_{0,15} und einer zweiten Halbleiterschicht 12 aus GaAs_{0,65}P_{0,35} enthält. Durch die zusätzlich in der Halbleiterschichtenfolge 13 enthaltene Übergitterstruktur 10 wird eine bessere Verminderung der Ausbreitung von Versetzungen und somit eine Verbesserung der Kristallqualität der Oberfläche 9 der Halbleiterschichtenfolge 13 und somit ein verbessertes Quasisubstrat 8 erzielt.

Der Verlauf des Phosphoranteils x und der relativen Änderung der Gitterkonstanten ε in Abhängigkeit von einer vom Substrat ausgehenden Ortskoordinate z bei dem Ausführungsbeispiel der Erfindung ist in Figur 2B dargestellt.

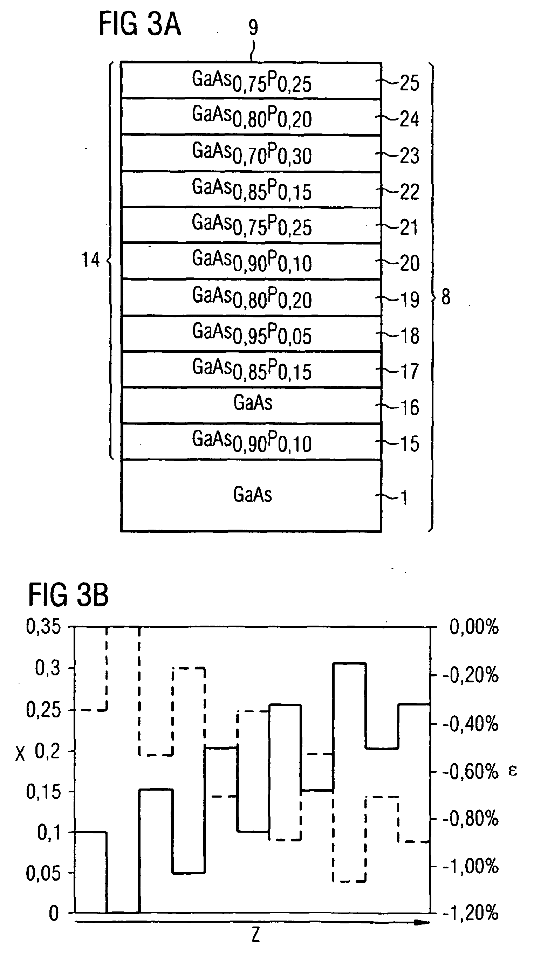

Ein weiteres Halbleitersubstrat mit einer darauf aufgebrachten Halbleiterschichtenfolge ist in Figur 3A schematisch im Querschnitt dargestellt. Hier ist eine Halbleiterschichtenfolge 14 auf ein GaAs-Substrat 1 aufgebracht, die insgesamt 11 Halbleiterschichten enthält. Die Halbleiterschichtenfolge 14 enthält ausgehend vom GaAs-Substrat 1 eine GaAs_{0,90}P_{0,10}-Schicht 15, eine GaAs-Schicht 16, eine GaAs_{0,85}P_{0,15}-Schicht 17, eine GaAs_{0,95}P_{0,05}-Schicht 18, eine GaAs_{0,80}P_{0,20}-Schicht 19, eine GaAs_{0,90}P_{0,10}-Schicht 20, eine GaAs_{0,75}P_{0,25}-Schicht 21, eine GaAs_{0,85}P_{0,15}-Schicht 22, eine GaAs_{0,70}P_{0,30}-Schicht 23, eine GaAs_{0,80}P_{0,20}-Schicht 24 und eine GaAs_{0,75}P_{0,25}-Schicht 25.

Der in Figur 3B schematisch dargestellte Verlauf des Phosphoranteils x und der relativen Änderung der Gitterkonstanten ε in Abhängigkeit von einer vom Substrat 1 ausgehenden Ortskoordinate z verdeutlicht, dass der Phosphoranteil x in der Halbleiterschichtenfolge 14 auf einen Wert von x = 0,25 in der obersten Halbleiterschicht 25 schrittweise erhöht wird, wobei der Phosphoranteil aber nicht in jeder Halbleiterschicht größer als in der in Wachstumsrichtung darunter liegenden Halbleiterschicht ist, sondern in mehreren Halbleiterschichten auch geringer ist als in der in Wachstumsrichtung darunter liegenden Halbleiterschicht. Der Verlauf des Phosphoranteils in der Halbleiterschichtenfolge 14 entspricht also einer Übergitterstruktur aus alternierenden ersten Halbleiterschichten und zweiten Halbleiterschichten, bei der der Phosphoranteil der ersten Halbleiterschicht und der zweiten Halbleiterschicht bei jedem Schichtpaar jeweils gegenüber dem darunter liegenden Schichtpaar erhöht wird. Auf diese Weise werden die vorteilhaften Eigenschaften des stufenweisen Anstiegs des Phosphoranteils und der Übergitterstruktur, insbesondere hinsichtlich der Verminderung der Ausbreitung von Versetzungen, in einer einzigen Halbleiterschichtenfolge 14 miteinander kombiniert.

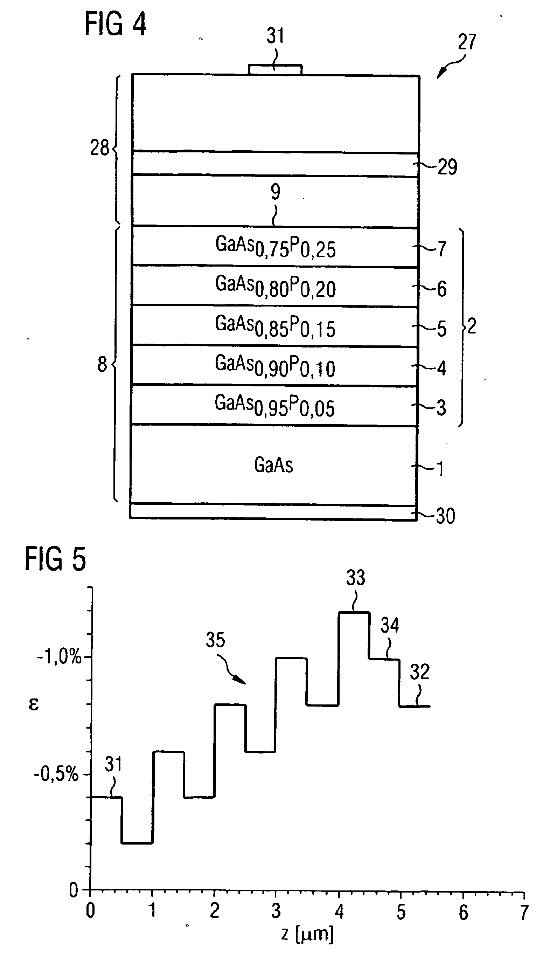

In Figur 4 ist ein Beispiel eines Halbleiterbauelements schematisch im Querschnitt dargestellt. Bei dem Halbleiterbauelement 27 handelt es sich um eine Lumineszenzdiode, die ein GaAs-Substrat 1 mit einer darauf aufgebrachten Halbleiterschichtenfolge 2 enthält.

Der Aufbau der Halbleiterschichtenfolge 2 ist der gleiche wie bei dem zuvor in Figur beschriebenen, d. h. die Halbleiterschichtenfolge 2 enthält fünf Halbleiterschichten 3, 4, 5, 6, 7 aus GaAs₁₋ₓPₓ, wobei der Phosphoranteil x von einem Wert von x = 0,05 in der an das GaAs-Substrat 1 angrenzenden Halbleiterschicht 3 auf einen Wert x = 0,25 in der obersten Halbleiterschicht 7 stufenweise ansteigt.

Das GaAs-Substrat 1 mit der darauf aufgebrachten Halbleiterschichtenfolge 2 stellt ein Quasisubstrat 8 dar, auf dessen Oberfläche 9 eine weitere Halbleiterschichtenfolge 28 epitaktisch aufgewachsen ist. Die Halbleiterschichtenfolge 28 basiert auf einem Halbleitermaterial, das eine geringere Gitterkonstante als GaAs aufweist.

In der Halbleiterschichtenfolge 28 ist eine strahlungsemittierende aktive Schicht 29 enthalten, die beispielsweise InₓGa_{y}Al₁₋ₓ₋₁P mit 0 < x < 0,5, 0 ≤ y ≤ 1 und x + y ≤ 1 enthält.

Alternativ enthält die strahlungsemittierende aktive Schicht 29 zum Beispiel eines der Halbleitermaterialien ZnSSe, ZnMgSSe, GaAsN oder InGaAsN.

Zur elektrischen Kontaktierung der Lumineszenzdiode kann beispielsweise eine erste elektrische Kontaktschicht 30 an der von der Halbleiterschichtenfolge 2 abgewandten Rückseite des Substrats 1 und eine zweite elektrische Kontaktschicht 31 auf der vom Substrat 1 abgewandten Oberfläche der Halbleiterschichtenfolge 28 vorgesehen sein.

In Figur 5 ist der Verlauf der relativen Änderung der Gitterkonstanten ε in Abhängigkeit von einer von einem Halbleitersubstrat ausgehenden Ortskoordinate z dargstellt. Hier ist zur Erzeugung eines Quasisubstrats eine Halbleiterschichtenfolge 35 mit insgesamt 11 Halbleiterschichten auf das Halbleitersubstrat aufgebracht. Die an das Substrat angrenzende Schicht 31 weist gegenüber dem Substrat eine Gitterfehlanpassung von ε = - 0,4 % auf. Die Oberfläche der obersten Halbleiterschicht 32 fungiert als Quasisubstrat, wobei in der obersten Halbleiterschicht ε = - 0,8 % gilt. Die Änderung von ε erfolgt in der Halbleiterschichtenfolge 35 stufenweise bis auf ε = - 1,2 % in der 9. Schicht 33.

Die beiden der obersten Halbleiterschicht vorangehenden Schichten 33, 34 weisen also jeweils eine kleinere Gitterkonstante auf als Quasisubstrat vorgesehene oberste Halbleiterschicht 32. Eine derartige Überkompensation der Gitterkonstante in den der obersten Halbleiterschicht 32 vorangehenden Schichten 33, 34 begünstigt die vollständige Relaxation der obersten Halbleiterschicht 32 vor dem Aufbringen weiterer Schichten, zum Beispiel einer LED-Schichtenfolge, auf die als Quasisubstrat fungierende oberste Halbleiterschicht 32.

## Patentansprüche

1. Optoelektronisches Bauelement mit einem Halbleitersubstrat (1) aus GaAs mit einer darauf aufgebrachten Halbleiterschichtenfolge (13),
die eine Mehrzahl von Halbleiterschichten aus Al_{1-y}Ga_{y}As₁₋ₓPₓ mit 0 ≤ x ≤ 1 und 0 ≤ y ≤ 1 enthält,
wobei die Halbleiterschichtenfolge mehrere aufeinander folgende Halbleiterschichten aufweist, in denen der Phosphorgehalt stufenweise ansteigt, und den Halbleiterschichten mit stufenförmig ansteigendem Phosphorgehalt eine Übergitterstruktur (10) aus alternierenden ersten Halbleiterschichten (11) und zweiten Halbleiterschichten (12) nachfolgt, wobei die ersten Halbleiterschichten (11) einen Phosphoranteil x₁ ≥ 0 und die zweiten Halbleiterschichten (12) einen Phosphoranteil x₂ ≥ 0 mit x₁ ≠ x₂ enthalten,
wobei
auf die Halbleiterschichtenfolge (13) eine weitere Halbleiterschichtenfolge (28) epitaktisch aufgewachsen ist, welche eine strahlungsemittierende oder strahlungsdetektierende Schicht (29) des optoelektronischen Bauelements enthält, so dass das Halbleitersubstrat (1) aus GaAs mit der darauf aufgebrachten Halbleiterschichtenfolge (13) als Quasisubstrat für die weitere Halbleiterschichtenfolge (28) fungiert.

2. Optoelektronisches Bauelement nach Anspruch 1,
**dadurch gekennzeichnet, dass**
der Phosphoranteil x in mindestens 2 Halbleiterschichten der Halbleiterschichtenfolge (13) größer als in einer benachbarten, in Wachstumsrichtung der Halbleiterschichtenfolge darunter liegenden Halbleiterschicht ist.

3. Optoelektronisches Bauelement nach Anspruch 1 oder 2,
**dadurch gekennzeichnet, dass**
der Phosphoranteil x in mindestens 3 aufeinander folgenden Halbleiterschichten der Halbleiterschichtenfolge (13) stufenweise ansteigt.

4. Optoelektronisches Bauelement nach einem der vorhergehenden Ansprüche,
**dadurch gekennzeichnet, dass**
für den Phosphoranteil x in der obersten Halbleiterschicht (12) der Halbleiterschichtenfolge (13) x ≥ 0,15 gilt.

5. Optoelektronisches Bauelement nach einem der vorhergehenden Ansprüche,
**dadurch gekennzeichnet, dass**
für den Aluminiumanteil 1 - y in der Halbleiterschichtenfolge (13) 1 - y = 0 gilt.

6. Optoelektronisches Bauelement nach einem der vorhergehenden Ansprüche,
**dadurch gekennzeichnet, dass**
die Gesamtdicke der Halbleiterschichtenfolge (13) 10 µm oder weniger beträgt.

7. Optoelektronisches Bauelement nach einem der vorhergehenden Ansprüche,
**dadurch gekennzeichnet, dass**
die Halbleiterschichten eine Dicke zwischen einschließlich 100 nm und einschließlich 1000 nm aufweisen.

8. Optoelektronisches Bauelement nach einem der vorhergehenden Ansprüche,
**dadurch gekennzeichnet, dass**
die oberste Halbleiterschicht (12) der Halbleiterschichtenfolge (13) eine kleinere Gitterkonstante aufweist als das GaAs-Substrat (1).

9. Optoelektronisches Bauelement nach einem der vorhergehenden Ansprüche,
**dadurch gekennzeichnet, dass**
die oberste Halbleiterschicht (12) der Halbleiterschichtenfolge (13) eine kleinere Gitterkonstante aufweist als zumindest eine der vorangehenden Halbleiterschichten.

10. Optoelektronisches Bauelement nach einem der vorhergehenden Ansprüche,
**dadurch gekennzeichnet, dass**
mindestens eine Halbleiterschicht der Halbleiterschichtenfolge (13) relaxiert ist.

11. Optoelektronisches Bauelement nach Anspruch 10,
**dadurch gekennzeichnet, dass**
die oberste Halbleiterschicht (12) der Halbleiterschichtenfolge (13) relaxiert ist.

12. Optoelektronisches Bauelement nach einem der vorhergehenden Ansprüche,
**dadurch gekennzeichnet, dass**
das optoelektronische Bauelement (27) eine Lumineszenzdiode oder ein Halbleiterlaser ist.

13. Optoelektronisches Bauelement nach einem der vorhergehenden Ansprüche,
**dadurch gekennzeichnet, dass**
die strahlungsdetektierende oder strahlungsemittierende Schicht (29) InₓAl_{y}Ga_{1-x-y}P mit 0 ≤ x < 0,5, 0 ≤ y ≤ 1 und x + y ≤ 1 enthält.

14. Optoelektronisches Bauelement nach einem der Ansprüche 1 bis 12,
**dadurch gekennzeichnet, dass**
die strahlungsdetektierende oder strahlungsemittierende Schicht (29) ZnSSe oder ZnMgSSe enthält.

15. Optoelektronisches Bauelement nach einem der Ansprüche 1 bis 12,
**dadurch gekennzeichnet, dass**
die strahlungsdetektierende oder strahlungsemittierende Schicht (29) GaAsN oder InGaAsN enthält.

## Claims

1. Optoelectronic component comprising a semiconductor substrate (1) composed of GaAs with a semiconductor layer sequence (13) applied thereto and containing a plurality of semiconductor layers composed of Al_{1-y}Ga_{y}As₁₋ₓPₓ where 0 ≤ x ≤ 1 and 0 ≤ y ≤ 1, wherein the semiconductor layer sequence has a plurality of successive semiconductor layers in which the phosphorus content rises step by step, and the semiconductor layers having the phosphorus content rising in a step manner are followed by a superlattice structure (10) composed of alternating first semiconductor layers (11) and second semiconductor layers (12), wherein the first semiconductor layers (11) contain a phosphorus portion x₁ ≥ 0 and the second semiconductor layers (12) contain a phosphorus portion x₂ ≥ 0 where x₁ ≠ x₂,
wherein
a further semiconductor layer sequence (28) containing a radiation-emitting or radiation-detecting layer (29) of the optoelectronic component is grown epitaxially onto the semiconductor layer sequence (13), such that the semiconductor substrate (1) composed of GaAs with the semiconductor layer sequence (13) applied thereto functions as a quasi-substrate for the further semiconductor layer sequence (28).

2. Optoelectronic component according to Claim 1,
**characterized in that**
the phosphorus portion x in at least two semiconductor layers of the semiconductor layer sequence (13) is greater than in an adjacent semiconductor layer situated underneath in the growth direction of the semiconductor layer sequence.

3. Optoelectronic component according to Claim 1 or 2,
**characterized in that**
the phosphorus portion x rises step by step in at least three successive semiconductor layers of the semiconductor layer sequence (13).

4. Optoelectronic component according to any of the preceding claims,
**characterized in that**
x ≥ 0.15 holds true for the phosphorus portion x in the topmost semiconductor layer (12) of the semiconductor layer sequence (13).

5. Optoelectronic component according to any of the preceding claims,
**characterized in that**
1 - y = 0 hold true for the aluminium portion 1 - y in the semiconductor layer sequence (13).

6. Optoelectronic component according to any of the preceding claims,
**characterized in that**
the total thickness of the semiconductor layer sequence (13) is 10 µm or less.

7. Optoelectronic component according to any of the preceding claims,
**characterized in that**
the semiconductor layers have a thickness of between 100 nm and 1000 nm inclusive.

8. Optoelectronic component according to any of the preceding claims,
**characterized in that**
the topmost semiconductor layer (12) of the semiconductor layer sequence (13) has a smaller lattice constant than the GaAs substrate (1).

9. Optoelectronic component according to any of the preceding claims,
**characterized in that**
the topmost semiconductor layer (12) of the semiconductor layer sequence (13) has a smaller lattice constant than at least one of the preceding semiconductor layers.

10. Optoelectronic component according to any of the preceding claims,
**characterized in that**
at least one semiconductor layer of the semiconductor layer sequence (13) is relaxed.

11. Optoelectronic component according to Claim 10,
**characterized in that**
the topmost semiconductor layer (12) of the semiconductor layer sequence (13) is relaxed.

12. Optoelectronic component according to any of the preceding claims,
**characterized in that** the optoelectronic component (27) is a luminescence diode or a semiconductor laser.

13. Optoelectronic component according to any of the preceding claims,
**characterized in that**
the radiation-detecting or radiation-emitting layer (29) contains InₓAl_{y}Ga_{1-x-y}P where 0 ≤ x < 0.5, 0 ≤ y ≤ 1 and x + y ≤ 1.

14. Optoelectronic component according to any of Claims 1 to 12,
**characterized in that**
the radiation-detecting or radiation-emitting layer (29) contains ZnSSe or ZnMgSSe.

15. Optoelectronic component according to any of Claims 1 to 12,
**characterized in that**
the radiation-detecting or radiation-emitting layer (29) contains GaAsN or InGaAsN.

## Revendications

1. Composant optoélectronique comportant un substrat semi-conducteur (1) constitué de GaAs revêtu d'une séquence de couches semi-conductrices (13) qui contient une pluralité de couches semi-conductrices constituées d'Al_{1-y}Ga_{y}As₁₋ₓPₓ, avec 0 ≤ x ≤ 1 et 0 ≤ y ≤ 1, dans lequel la séquence de couches semi-conductrices comprend une pluralité de couches semi-conductrices successives dans lesquelles la teneur en phosphore croît par pas successifs, et une structure de super-réseau (10) constituée de premières couches semi-conductrices alternées (11) et de secondes couches semi-conductrices (12) fait suite aux couches semi-conductrices ayant une teneur en phosphore croissant par pas successifs, dans lequel les premières couches semi-conductrices (11) présentent une teneur en phosphore x₁ ≥ 0 et les secondes couches semi-conductrices (12) présentent une teneur en phosphore x₂ ≥ 0, avec x₁ ≠ x₂, dans lequel une séquence de couches semi-conductrices supplémentaire (28) qui contient une couche émettrice de rayonnement (29) ou détectrice de rayonnement du composant optoélectronique est formée par croissance épitaxiale sur la séquence de couches semi-conductrices (13), de manière à ce que le substrat semi-conducteur (1) constitué de GaAs revêtu de la séquence de couches semi-conductrices (13) se comporte comme un quasi-substrat pour la séquence de couches semi-conductrices supplémentaire (28).

2. Composant optoélectronique selon la revendication 1, **caractérisé en ce que** la teneur en phosphore x dans au moins 2 couches semi-conductrices de la séquence de couches semi-conductrices (13) est supérieure à celle d'une couche semi-conductrice voisine située en dessous de celle-ci dans la direction de croissance de la séquence de couches semi-conductrices.

3. Composant optoélectronique selon la revendication 1 ou 2, **caractérisé en ce que** la teneur en phosphore x dans au moins 3 couches semi-conductrices successives de la séquence de couches semi-conductrices (13) croît par pas successifs.

4. Composant optoélectronique selon l'une des revendications précédentes, **caractérisé en ce que**, pour la teneur en phosphore x dans la couche semi-conductrice supérieure (12) de la séquence de couches semi-conductrices (13), on a x ≥ 0,15.

5. Composant optoélectronique selon l'une des revendications précédentes, **caractérisé en ce que** pour la proportion d'aluminium 1-y dans la séquence de couches semi-conductrices (13), on a 1-y = 0.

6. Composant optoélectronique selon l'une des revendications précédentes, **caractérisé en ce que** l'épaisseur totale de la séquence de couches semi-conductrices (13) est de 10 µm ou moins.

7. Composant optoélectronique selon l'une des revendications précédentes, **caractérisé en ce que** les couches semi-conductrices présentent une épaisseur allant de 100 nm inclus à 1000 nm inclus.

8. Composant optoélectronique selon l'une des revendications précédentes, **caractérisé en ce que** la couche semi-conductrice supérieure (12) de la séquence de couches semi-conductrices (13) présente une constante de réseau inférieure à celle du substrat de GaAs (1).

9. Composant optoélectronique selon l'une des revendications précédentes, **caractérisé en ce que** la couche semi-conductrice supérieure (12) de la séquence de couches semi-conductrices (13) présente une constante de réseau inférieure à celle d'au moins l'une des couches semi-conductrices précédentes.

10. Composant optoélectronique selon l'une des revendications précédentes, **caractérisé en ce qu'**au moins une couche semi-conductrice de la séquence de couches semi-conductrices (13) est relaxée.

11. Composant optoélectronique selon la revendication 10, **caractérisé en ce que** la couche semi-conductrice supérieure (12) de la séquence de couches semi-conductrices (13) est relaxée.

12. Composant optoélectronique selon l'une des revendications précédentes, **caractérisé en ce que** le composant optoélectronique (27) est une diode électroluminescente ou un laser à semi-conducteur.

13. Composant optoélectronique selon l'une des revendications précédentes, **caractérisé en ce que** la couche détectrice de rayonnement ou émettrice de rayonnement (29) contient de l'InₓAl_{y}Ga_{1-x-y}P avec 0 ≤ x < 0,5, 0 ≤ y ≤ 1 et x+y ≤ 1.

14. Composant optoélectronique selon l'une des revendications 1 à 12, **caractérisé en ce que** la couche détectrice de rayonnement ou émettrice de rayonnement (29) contient du ZnSSe ou du ZnMgSSe.

15. Composant optoélectronique selon l'une des revendications 1 à 12, **caractérisé en ce que** la couche détectrice de rayonnement ou émettrice de rayonnement (29) contient du GaAsN ou de l'InGaAsN.
